# EUROPEAN PATENT APPLICATION

(11) **EP 4 391 010 A1**
(43) Date of publication of application: **26.06.2024**
(21) Application number: 23191350.0
(22) Date of filing: 14.08.2023
(51) Int. Cl.: H01J 37/32, H01L 21/683

(54) **METHOD AND APPARATUS FOR PLASMA ETCHING DIELECTRIC SUBSTRATES**

(30) Priority: 21.12.2022 GB 202219448
(71) Applicant: SPTS Technologies Limited, Newport Gwent NP18 2TA (GB)
(72) Inventor: RUBIN, Andrew, Newport (GB); RIDDEL, Kevin, Newport (GB); LAUNAY, Nicolas, Newport (GB)
(74) Representative: Wynne-Jones IP Limited

(57) **Abstract**

A method of plasma etching a workpiece and a plasma etching apparatus are provided.

## Description

The present invention relates to a method of plasma etching a workpiece and an electrostatic chuck ("ESC") for use in a plasma etching apparatus.

### Background

In vacuum-based plasma etch and deposition tools in the semiconductor fabrication industry, it is challenging to remove heat produced by a plasma or exothermic process from a wafer or substrate due to the sub-atmospheric pressure in the process chamber. The reduced pressure limits heat transfer due to poor convection and direct conduction of the heat from the substrate to the substrate support. In order to achieve optimal control of substrate temperature, electrostatic chucks or "ESCs" are used to control the temperature of a substrate in a vacuum system. Electrostatic attraction between the ESC and the substrate allows pressurization of cavities or channels between the substrate and the surface of the ESC with an inert gas such as He at a sufficiently high pressure to facilitate good thermal conduction between the substrate and the thermally controlled ESC. This process is known as backside pressurization. Even when the process chamber is operating at substantially lower pressures than the pressure between the ESC and the substrate, it is possible to maintain electrostatic clamping of the substrate and in turn tight temperature control.

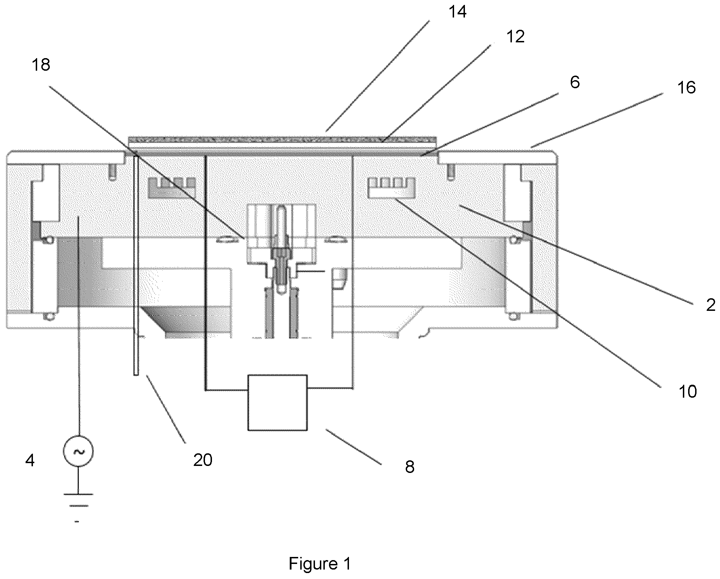

There are in general two distinct varieties of ESCs used to clamp substrates in vacuum systems, namely bipolar ("Coloumb") and monopolar ("Johnsen-Rahbek") ESCs. In both types, a metallic electrode or multiple electrodes are encapsulated in a dielectric structure which is then attached to a metallic substrate support, as shown in Figure 1. A substrate support 2, which is typically fabricated from aluminium or stainless steel, is connected to an RF supply 4 and the electrostatic chuck ESC 6 is attached to an upper surface of the substrate support 2. The ESC 6 has metallic electrodes sandwiched between two layers of dielectric material. The electrodes are attached to high voltage DC power supplies 8 which, for relatively thick ceramic layers greater than 0.5 mm in thickness, can supply up to +/- 9 kV. For thinner polymer layers, such as polyimide, the layer thickness can be less than 0.1 mm, and the DC power is typically supplied at less than +/- 2 kV. Backside gas entry for the refrigerant gas, typically He or Ar, is provided by a pipe 20 in the substrate support 2 and allows gas to be injected between the substrate 12 and the surface of the ESC 6. Coolant channels 10 enable a flow of refrigerant to remove heat from the substrate support 2 while resistive heaters (not shown) can facilitate elevated temperature operation. Loading and unloading of substrate 12 with coating 14 is achieved using lift assembly 18. Shield ring 16, typically formed from ceramic, protects the substrate support 2 from the plasma and helps shape the plasma in the vicinity of the substrate 12.

In a bipolar ESC, there are at least two electrodes of opposite polarity which produce an electrostatic field at the back of the substrate. This requires the substrate to support charge movement, i.e. the substrate must be formed from a semiconductor or metallic material. As the majority of substrates processed in the semiconductor and optoelectrics industry are themselves semiconductors, bipolar ESCs are widely used. However, as new applications develop where the substrate in contact with the ESC is not conductive, alternative approaches for cooling wafers are required.

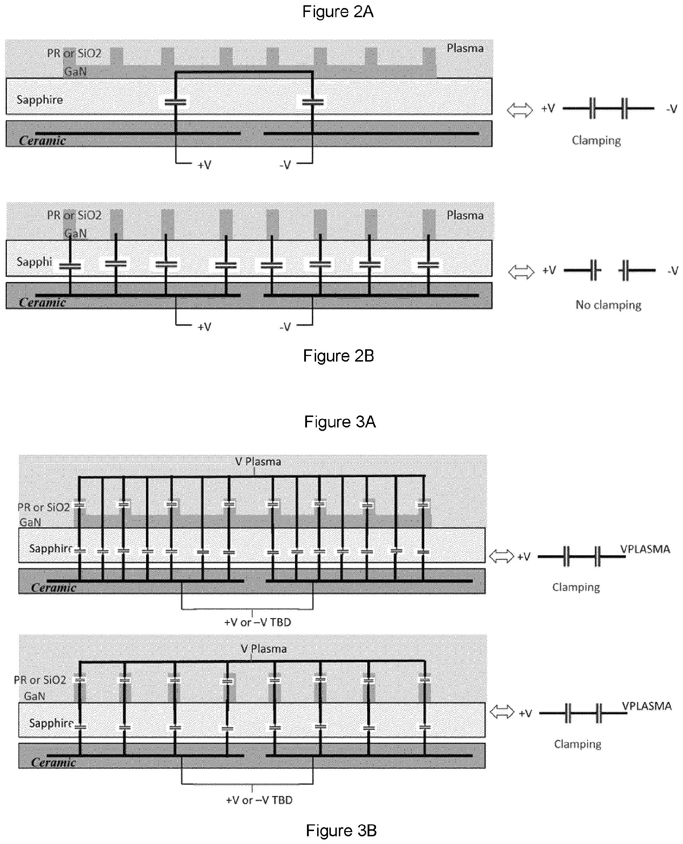

For example, the production of GaN-based micro-LEDs involves the isolation of discrete regions of GaN, typically deposited onto sapphire substrates. This type of application highlights a significant problem for heat management and wafer retention in a vacuum-based process system. To isolate the micro-LEDs, a mask is applied to the device and a plasma etch process is used to etch the uncovered GaN layer of the device down to the sapphire substrate. This results in the isolation of many hundreds of thousands of micro-LEDS having dimensions less than 40 µm, even on a 150mm sapphire wafer. Once the GaN micro-LEDs are isolated, they are removed from the sapphire substrate by a lift-off process and are then assembled into arrays. However, once the semiconductive GaN layer ceases to be continuous, the conventional form of bipolar electrostatic clamping methods fail to work. As shown in Figure 2A, when there is a continuous layer of a semiconductor, such as GaN, on the dielectric substrate, such as sapphire, the bipolar ESC can retain the wafer through electrostatic attraction between the GaN/sapphire and the surface of the ESC. However when the etch process produces small islands of GaN, as shown in Figure 2B, the clamping fails as the individual metal electrodes couple directly to the individual islands and bipolar coupling is lost.

Monopolar ESCs have an electrode or electrodes maintained at a single potential and rely on an external source of electrons to produce the electrostatic field. Generation of a plasma with the plasma chamber typically provides a current path to ground and, in turn, enables the monopolar ESC to clamp the substrate to the substrate support. As shown in Figures 3A and 3B, the monopolar ESC will clamp the substrate to the ESC regardless of whether a continuous layer of conductive or semiconductive material is present or not. However, as this requires the plasma to commence before the clamping can occur, there will be some undesirable heating of the wafer before the ESC can clamp the substrate and provide cooling. Charge build-up between the ESC and the dielectric substrate can also be a concern, as this can result in problems when the substrate is de-clamped. This can result in handling problems which can potentially end up with substrates being mishandled.

Alternatively, an ESC with interdigitated electrodes, such as that shown in US 9793149 B2, can be used to clamp dielectric substrates. An interdigitated ESC needs a thin top layer of ceramic to allow enough electric field to pass through the ceramic to the wafer. As the ESC is exposed to the plasma, mainly during inter-substrate cleaning, the top ceramic is consumed, and therefore a thin ceramic means a shorter ESC lifetime.

Alternative means of retaining the substrate include mechanical clamps or additional conductive coatings on the backside of the substrate. However, edge exclusion and particle generation are problematic for clamp rings, while depositing a conductive layer on the lower surface of the dielectric substrate adds additional process steps by adding and removing the layer from the substrate and potential contamination concerns.

What is therefore required is an improved method of plasma etching that can maintain the required clamping and control of heat transfer between the substrate and the substrate support for dielectric substrates.

### Statement of Invention

The present invention, in at least some of its embodiments, seeks to address at least some of the above described problems, desires and needs.

According to a first aspect of the invention there is provided a method of plasma etching a workpiece, the method comprising:
- locating a workpiece on a substrate support within a plasma chamber, wherein the workpiece comprises a dielectric substrate and at least one semiconductor layer on the dielectric substrate, and the substrate support comprises an electrostatic chuck ("ESC"), the ESC comprising at least two electrodes;
- applying a positive voltage to one of the electrodes and a negative voltage to another of the electrodes in a first bipolar mode of operation such that the workpiece is electrostatically clamped to the ESC;
- plasma etching the at least one semiconductor layer by generating a plasma in the plasma chamber, wherein, at a period of time after the plasma is ignited, the operation of the ESC is switched to a monopolar mode of operation in which the electrodes have the same voltage applied to each electrode; and
- switching the operation of the ESC to a second bipolar mode of operation in which a positive voltage is applied to one of the electrodes and a negative voltage is applied to another of the electrodes.

The present inventors have found that, by switching the ESC between bipolar and monopolar modes during the plasma etching of the semiconductor layer, clamping of the substrate and sufficient heat transfer to and from the substrate can be ensured throughout the etching process, even for a dielectric substrate.

The step of switching the operation of the ESC to a second bipolar mode of operation can be performed after the step of plasma etching the at least one semiconductor layer has finished. Alternatively, the step of switching the operation of the ESC to the second bipolar mode of operation can be performed during the step of plasma etching the at least one semiconductor layer. The presence of the plasma in the plasma chamber whilst the ESC is in the second bipolar mode assists in the reduction in charge retention in the dielectric substrate, which assists with removal of the workpiece from the chamber when etching is completed.

The step of plasma etching the at least one semiconductor layer can comprise a first, bulk, etch phase in which a majority of the etching is performed until an end-point is reached, and a second, over etch phase, wherein the step of switching the operation of the ESC to a second bipolar mode of operation is performed on reaching the end point or during the second etch phase. The ESC can be maintained in the second bipolar mode of operation for a period of time after the step of plasma etching the at least one semiconductor layer has finished. The step of plasma etching the at least one semiconductor layer can comprise etching through the at least one semiconductor layer to form a plurality of discrete regions of semiconductor on the dielectric substrate, wherein the step of switching the operation of the ESC to a monopolar mode of operation is performed prior to the formation of the discrete regions of semiconductor. If the step of plasma etching the at least one semiconductor layer comprises the first etch phase and second etch phase, the step of switching the operation of the ESC to the monopolar operation can be performed before the end of the first etch phase.

The absolute value of the voltage applied to each of the electrodes can be the same in the first bipolar mode of operation. The absolute value of the voltage applied to each of the electrodes can be the same in the second bipolar mode of operation. The absolute value of the voltage applied to the electrodes in the first bipolar mode of operation can be the same as the absolute value of the voltage applied to the electrodes in the second bipolar mode of operation. Alternatively, the absolute value of the voltage applied to the electrodes in the second bipolar mode of operation can be different to the absolute value of the voltage applied to the electrodes in the first bipolar mode of operation. For example, the absolute value of the voltage applied to the electrodes in the second bipolar mode of operation can be lower than the absolute value of the voltage applied to the electrodes in the first bipolar mode of operation. Having the absolute value of the voltage in the second bipolar mode of operation being lower than the absolute value of the voltage applied in the first bipolar mode of operation can help reduce the charge that can build up on the dielectric substrate.

In one aspect of the invention, in the first bipolar mode of operation, a positive voltage is applied to a first electrode and a negative voltage is applied to a second electrode, and in the second bipolar mode of operation, a negative voltage is applied to the first electrode and a positive voltage is applied to the second electrode. The present inventors have found that reversing the polarity of the electrodes in this manner helps to reduce charge that may have built up on the dielectric substrate. Alternatively, a positive voltage can be applied to a first electrode and a negative voltage can be applied to a second electrode in both the first bipolar mode of operation and second bipolar mode of operation.

The absolute value of the voltage applied to at least one of the electrodes in the first bipolar mode of operation can be up to 9000 V, optionally up to 6000 V. The absolute value of the voltage applied to at least one of the electrodes in the first bipolar mode of operation can be at least 4000 V, optionally at least 5000 V. The absolute value of the voltage applied to at least one of the electrodes in the second bipolar mode of operation can be up to 9000 V, optionally up to 6000 V. The absolute value of the voltage applied to at least one of the electrodes in the second bipolar mode of operation can be at least 4000 V, optionally at least 5000 V. The absolute value of the voltage applied to the electrodes in the monopolar mode of operation can be up to 9000 V, optionally up to 6000 V. The absolute value of the voltage applied to the electrodes in the monopolar mode of operation can be at least 4000 V, optionally at least 5000 V.

The step of plasma etching the at least one semiconductor layer by generating a plasma in the plasma chamber may comprise introducing a gas or gas mixture into the plasma chamber and generating a plasma in the plasma chamber from the gas or gas mixture using a plasma generation device. The step of plasma etching the at least one semiconductor layer by generating a plasma in the plasma chamber can comprise evacuating the plasma chamber to a predetermined pressure. The predetermined pressure can be at least 1 mTorr. The predetermined pressure can be up to 200 mTorr.

The method can further comprise the step of:
- introducing one or more inert gases into at least one channel formed on the surface of the substrate support between the substrate support and the dielectric substrate.

The one or more inert gases can be introduced into the at least one channel at a flow rate that results in a back side pressure of between 3 and 20 Torr. The step of introducing one or more inert gases can comprise reducing the flow rate of the one or more inert gases or inert gas mixture during the period in which the ESC is in the second bipolar mode of operation. Optionally, the flow rate of the at least one inert gas can be reduced to zero, such that the flow of the one or more inert gases into the at least one channel is stopped. The one or more inert gases or inert gas mixture can comprise at least one of He or Ar.

The at least one semiconductor layer can comprise at least one Gallium Nitride layer. The dielectric substrate can be formed of ceramic AlN, SiO₂, Al₂O₃ or sapphire. The dielectric substrate can be formed of sapphire.

According to a second aspect of the invention, there is provided a plasma etching apparatus comprising:
- a plasma chamber;
- a plasma generation device;
- a controller; and
- a substrate support,
wherein the substrate support comprises an electrostatic chuck ("ESC"), the electrostatic chuck comprising:
- at least two electrodes;
- a power supply; and
- a layer of dielectric material covering the at least two electrodes and forming a substrate support surface,
wherein the controller is configured to switch the ESC between a first bipolar mode of operation, a monopolar mode of operation and a second bipolar mode of operation, wherein the first bipolar mode of operation comprises applying a positive voltage to one of the electrodes and a negative voltage to another of the electrodes, the second bipolar mode of operation comprises applying a positive voltage to one of the electrodes and a negative voltage to another of the electrodes and the monopolar mode of operation comprises applying the same voltage to each of the at least two electrodes, and wherein, during the generation of a plasma within the plasma chamber by the plasma generation device, the controller is configured to switch the ESC from the first bipolar mode of operation to the monopolar mode of operation whilst a plasma is generated within the plasma chamber.

The present inventors have found that the plasma etching apparatus can successfully maintain clamping and temperature control of the substrate during plasma etching, even for etching dielectric substrates.

The controller can be configured to switch the ESC from the monopolar mode of operation to the second bipolar mode of operation once generation of a plasma within the plasma chamber is finished. Alternatively, during generation of a plasma within the plasma chamber by the plasma generation device, the controller can be configured to switch the ESC from the monopolar mode of operation to the second bipolar mode of operation. The substrate support can comprise at least one channel formed on the surface of the substrate support between the substrate support and the substrate.

The power supply can be configured to apply a voltage to each of the electrodes having the same absolute value. The power supply can be configured to supply a positive voltage to one of the electrodes and a negative voltage to a second of the electrodes. The power supply can be configured to switchably supply a positive voltage or a negative voltage to each of the at least two electrodes. The power supply can be configured to supply a voltage having an absolute value of up to 9000 V, optionally up to 6000V, to at least one of the at least two electrodes. The power supply can be configured to supply a voltage having an absolute value of at least 4000 V, optionally at least 5000V, to at least one of the at least two electrodes.

The apparatus can further comprise at least one gas inlet for introducing a gas or gas mixture into the plasma chamber, wherein the controller is configured to control the flow of gas or gas mixture from the at least one gas inlet into the plasma chamber. The apparatus can further comprise at least one gas inlet for introducing one or more inert gases into the at least one channel formed on the surface of the substrate support, wherein the controller is configured to control the flow of one or more inert gases from the at least one gas inlet into the at least one channel. The controller can be configured to control the flow rate of one or more inert gases through the at least one gas inlet into the at least one channel.

The layer of dielectric material can have a thickness of at least 0.5 mm. Optionally, the layer of dielectric material can have a thickness of at least 1 mm. The resistivity of the layer of dielectric material can be at least 10¹² Ωcm at a temperature of 25 °C. The resistivity of the layer of dielectric materials can be up to 10¹⁵ Ωcm at a temperature of 25 °C. The dielectric constant of the layer of dielectric material can be at least 7 at a temperature of 25 °C. The layer of dielectric material can comprise at least one sapphire, ceramic AlN or Al₂O₃ layer.

Whilst the invention has been described above, it extends to any inventive combination of the features set out above, or in the following description, drawings or claims. For example, any features disclosed in relation to one aspect of the invention may be combined with any features disclosed in relation to any of the other aspects of the invention.

For the avoidance of doubt, whenever reference is made herein to 'comprising' or 'including' and like terms, the invention is also understood to include more limiting terms such as 'consisting' and 'consisting essentially'.

### Description of Figures

Embodiments of the invention will now be described, by way of example only, with reference to the accompanying drawings, in which:
Figure 1 is a schematic illustration of a known substrate support.
Figures 2A and 2B are schematic illustrations of operation of an ESC in a bipolar mode of operation whilst etching a semiconductor layer on a dielectric substrate A) whilst the semiconductor layer is continuous and B) when the semiconductor layer is formed of discrete regions;
Figures 3A and 3B are schematic illustrations of operation of an ESC in a monopolar mode of operation whilst etching a semiconductor layer on a dielectric substrate A) whilst the semiconductor layer is continuous and B) when the semiconductor layer is formed of discrete regions;
Figure 4 is a flowchart of a method of plasma etching a workpiece according to a first embodiment of the present invention; and
Figure 5 is a flowchart of a method of plasma etching a workpiece according to a second embodiment of the present invention.

### Detailed Description

In the following description, examples were performed on an inductively coupled plasma (ICP)-based SPTS Synapse^{™} plasma etch tool, which is commercially available from SPTS Technologies Limited of Newport, South Wales, UK. However, the methods of the present invention may be performed on alternative plasma etch tools, preferably on other ICP-based etch tools. Examples used 150 mm sapphire wafers with a layer of Gallium Nitride (GaN) deposited on a surface thereon as the workpiece to be processed. However, the methods of the invention may equally be applied to different substrate materials, layer materials, layer configurations and geometries.

Where the same reference numeral has been used in different figures and/or embodiments, the feature to which it relates corresponds to a substantially identical feature.

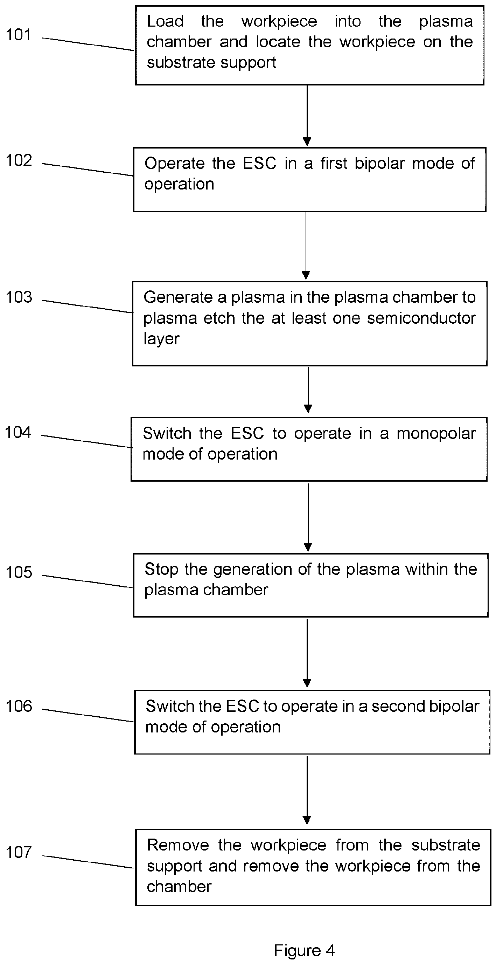

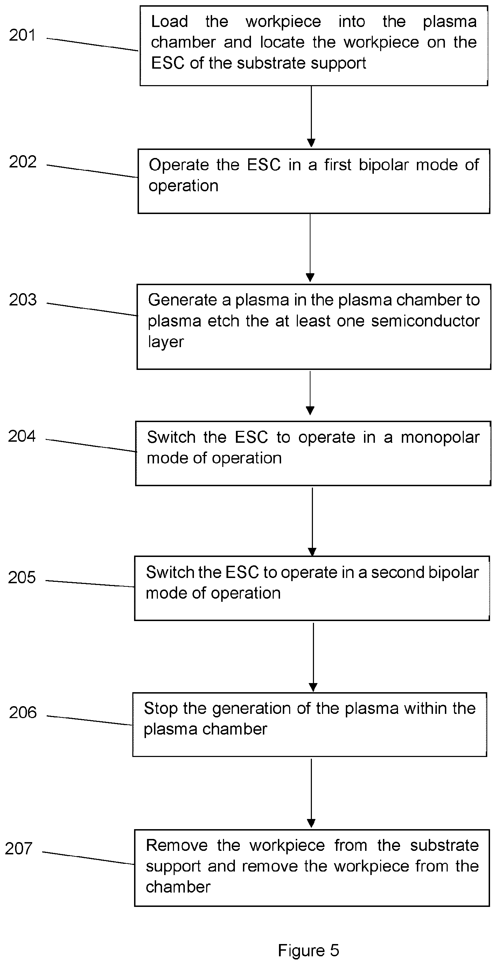

A method of plasma etching a workpiece according to a first exemplary embodiment of the present invention is illustrated by the flowchart of Figure 4. A method of plasma etching a workpiece according to a second exemplary embodiment of the present invention is illustrated by the flowchart of Figure 5.

The method of the first exemplary embodiment of the invention may be performed in a plasma etching apparatus comprising a plasma chamber, a substrate support for supporting the workpiece within the plasma chamber, at least one gas inlet for introducing a gas or gas mixture into the plasma chamber, at least one gas inlet for introducing one or more inert gases into at least one channel formed on the surface of the substrate support, a plasma generation device for generating a plasma within the plasma chamber, and a controller. The substrate support comprises an electrostatic chuck ("ESC"), the electrostatic chuck comprising at least two electrodes, a power supply, and a layer of dielectric material covering the at least two electrodes and forming a substrate support surface, the layer of dielectric material comprising the at least one channel.

In a loading step 101, the workpiece is loaded into the plasma chamber and located on the substrate support. The workpiece may be loaded into the plasma chamber by any means known in the art. In the exemplary embodiment, the workpiece is loaded into the plasma chamber and located on the substrate support by an end effector attached to a wafer transfer robot.

The workpiece comprises at least one semiconductor layer on a dielectric substrate. In the first exemplary embodiment, the at least one semiconductor layer is a layer of GaN, and the dielectric substrate is formed of sapphire. However, the method of the present invention may be equally applied to other semiconductor layers, such as silicon, and other dielectric substrates, such as those formed from ceramic AlN, SiO₂ or Al₂O₃. The GaN layer can have additional layers or deposits, such as a mask layer or photoresist layer, deposited on an upper surface thereof. As shown in Figures 2A, 2B, 3A and 3B, the GaN layer has individual deposits of SiO₂ formed on the surface of the GaN layer that act as a mask to prevent etching of the GaN layer below the SiO₂ deposits during etching of the substrate. This mask layer results in the formation of discrete "islands" of GaN which, as shown in Figure 2B, will not allow the substrate to clamp to the ESC and the substrate support.

The plasma chamber can be maintained under vacuum during the loading step 101. Alternatively, the plasma chamber can be at atmospheric pressure during the loading step 101.

In an operating step 102, the ESC of the substrate support is operated in a first bipolar mode of operation to electrostatically clamp the workpiece to the substrate support. In the first bipolar mode of operation, a positive voltage is applied to one of the electrodes of the ESC and a negative voltage is applied to another of the electrodes of the ESC by the power supply. If the ESC comprises more than two electrodes, the positive voltage can be applied to a first group of the electrodes and the negative voltage can be applied to a second group of the electrodes, or vice versa. In the exemplary embodiments, the positive voltage and the negative voltage have the same absolute value, for example +9000 V and -9000 V. The value of the positive voltage and negative voltage will be selected dependent on the thickness and dielectric properties of the substrate. The means for supplying electrical power to the at least two electrodes is preferably a high voltage power supply that is capable of applying a positive voltage or a negative voltage to each of the at least two electrodes of the ESC, and preferably the high voltage power supply is capable of switchably applying a positive voltage and a negative voltage to each of the at least two electrodes, such that the polarity of each electrode may be reversed without changing the power supply to the electrodes. The power supply is preferably capable of supplying a voltage of up to +/- 9000 V to each electrode.

In the exemplary embodiments, once the ESC is operated in the first bipolar mode of operation, one or more inert gases are introduced into the at least one channel formed on the surface of the ESC in a gas introduction step. This flow of inert gas(es) allows for improved thermal conduction between the substrate support and the substrate, especially if the chamber is evacuated, and the flow of inert gas(es) can be used to heat or, more typically, cool the substrate. If the plasma chamber is maintained under vacuum, the pressure within the chamber is typically between 1 mTorr and 200 mTorr, whereas the flow of one or more inert gases typically results in a back side pressure of between 3 and 20 Torr. In the exemplary embodiments, the one or more inert gases is He.

Once the ESC is in the first bipolar mode of operation, a plasma is generated in the plasma chamber to plasma etch the at least one semiconductor layer in a plasma etching step 103. The plasma may be generated in the plasma chamber using the plasma generation device by any means known in the art. In the exemplary embodiments, a gas or gas mixture is introduced into the plasma chamber through at least one gas inlet, and the plasma generation device, comprising an ICP source and a RF power supply to bias the substrate support, is configured to generate a plasma from the gas or gas mixture. The ICP source and RF power supply are both operated at a frequency of 13.56 MHz. The gas or gas mixture chosen will depend on the at least one semiconductor layer to be etched and the particular reaction conditions that are desired. In the exemplary embodiments of etching a GaN layer on sapphire, the gas or gas mixture comprises a mixture of Cl₂, BCl₃ and Ar gases. If the gas or gas mixture comprises a gas mixture, these gases can be introduced into the plasma chamber through a single gas inlet or can be introduced into the plasma chamber through respective gas inlets for each respective gas component of the gas mixture.

Once the plasma is generated and etching of the substrate has begun, the ESC is switched from the first bipolar mode of operation to a monopolar mode of operation in a first switching step 104. In the monopolar mode of operation, the same voltage is applied to each of the electrodes in the ESC, such that each electrode is maintained at the same polarity. For example, each electrode may have a voltage of -6000 V applied to it by the power supply. The selection of a positive or negative voltage will be dependent on the substrate to be etched and the nature of the generated plasma.

The point at which the ESC is switched from the first bipolar mode of operation to the monopolar mode of operation will be dependent on the particular etch being performed and the substrate to be etched. For example, in the exemplary embodiments, where the GaN layer is etched through to the sapphire layer below, the ESC will be switched to the monopolar mode of operation before the GaN layer is completely etched through to form discrete regions of semiconductor, in order to avoid the issues of clamping discrete regions of semiconductor material on the dielectric substrate in the first bipolar mode of operation. However, in each case, the switching of the ESC from the first bipolar mode of operation to the monopolar mode of operation will occur after the plasma has been generated, in order to ensure sufficient clamping of the workpiece to the substrate support.

In the first exemplary embodiment, after the ESC is switched into the monopolar mode of operation, the generation of plasma within the plasma chamber is stopped in a stopping step 105. In the exemplary embodiments, the stopping step 105 comprises ending the flow of gas or gas mixture into the plasma chamber and ending the operation of the RF power supply and ICP source. The stopping step 105 will typically be performed once it is determined that the plasma etch has been completed, for example using standard techniques such as optical interferometry. In some embodiments, the plasma etching of the at least one semiconductor layer comprises a first, bulk, etch phase, in which a majority of the etching and removal of semiconductor material is performed until an end-point is reached, and a second, over etch phase, in which the plasma is maintained until the features formed by the plasma etching process are fully formed, and the stopping step 105 occurs after the over etch phase is complete. If back side pressurization is present, the flow of one or more inert gases into the at least one channel can be reduced or stopped along with ending the plasma generation.

In the first exemplary embodiment, once plasma generation has been stopped in the stopping step 105, the ESC is switched from the monopolar mode of operation to a second bipolar mode of operation in a second switching step 106. As in the first bipolar mode of operation, in the second bipolar mode of operation, a positive voltage is applied to one of the electrodes and a negative voltage is applied to another of the electrodes. The second bipolar mode of operation may be similar to the first bipolar mode of operation in that the electrodes that have a positive voltage applied in the first bipolar mode of operation also have a positive voltage applied in the second bipolar mode of operation and the electrodes that have a negative voltage applied in the first bipolar mode of operation also have a negative voltage applied in the second bipolar mode of operation. Optionally, the absolute values of the voltages applied in the second bipolar mode of operation may be the same as the absolute values of the voltages applied in the first bipolar mode of operation. For example, a voltage of +6000 V can be applied to one electrode and a voltage of - 6000 V can be applied to another electrode in both the first bipolar mode of operation and the second bipolar mode of operation. Alternatively, the absolute values of the voltages applied in the second bipolar mode of operation may be different to the absolute values of the voltages applied in the first bipolar mode of operation. For example, a voltage of +6000 V can be applied to one electrode and a voltage of - 6000 V can be applied to another electrode in the first bipolar mode of operation, and the same electrodes can have voltages of +5000 V and -5000 V applied in the second bipolar mode of operation, respectively. In one embodiment, the polarity of the voltages applied to the electrodes may change between the first bipolar mode of operation and the second bipolar mode of operation. For example, in the first bipolar mode of operation, a positive voltage is applied to a first electrode and a negative voltage is applied to a second electrode, and in the second bipolar mode of operation, a negative voltage is applied to the first electrode and a positive voltage is applied to the second electrode. This reverse in the polarity of the electrodes can help reduce charge build-up in the dielectric substrate, which will facilitate its removal from the substrate support.

Once the plasma generation has ended and any charge build-up in the dielectric substrate has been removed, the ESC is turned off and the substrate is removed from the substrate support, and subsequently the plasma chamber in a removing step 107. The workpiece may be removed from the substrate support by any method known in the art, such as a lift mechanism to lift the workpiece above the surface of the substrate support, and the workpiece may be removed from the plasma chamber by the same method as it was introduced in the loading step 101, such as by an end effector attached to a wafer transfer robot.

In the second exemplary embodiment, a number of features are identical to those described in the first exemplary embodiment. For example, the loading step 201, operating step 202, plasma etching step 203, first switching step 204 and removing step 207 are substantially identical to the loading step 101, operating step 102, plasma etching step 103, first switching step 104 and removing step 107 respectively. However, the second exemplary embodiment differs from the first exemplary embodiment in that the second switching step 205 occurs before the stopping step 206, such that the ESC is operated in the second bipolar mode of operation whilst the plasma is still being generated. This switching to the second bipolar mode of operation whilst the plasma is still present can further aid in reduction of charge build-up on the dielectric substrate.

In the second exemplary embodiment, the ESC can be maintained in the second bipolar mode of operation for a period after the stopping step 206 until the ESC is turned off for the removing step 207. In the embodiment where an over etch is performed, the second switching step 205 can be performed at the end of the bulk etch or during the over etch.

### Example

A workpiece comprising a 5 µm thick layer of GaN on a 1 mm thick layer of sapphire, with a 2 µm thick SiO₂ hard mask deposited on the surface of the GaN layer, was loaded into a SPTS Technologies Ltd Synapse^{™} ICP plasma etch tool and the GaN layer was etched using a Cl₂/BCl₃/Ar plasma. Both the ICP source and RF bias used 13.56 MHz RF power supplies. The workpiece was clamped by a dual-electrode ESC, which was operated in a bipolar mode of operation (first electrode at +6000 V, second electrode at -6000 V) until the GaN layer was etched through, before being switched to a monopolar mode of operation (first and second electrode both at -6000 V) for an over etch. The ESC was switched to a second bipolar mode of operation (first electrode at +6000 V, second electrode at -6000 V) after the plasma etching was ended. It was found that the temperature of the workpiece was successfully maintained at the desired level and the substrate was successfully clamped throughout.

## Claims

1. A method of plasma etching a workpiece, the method comprising:
• locating a workpiece on a substrate support within a plasma chamber, wherein the workpiece comprises a dielectric substrate and at least one semiconductor layer on the dielectric substrate, and the substrate support comprises an electrostatic chuck ("ESC"), the ESC comprising at least two electrodes;
• applying a positive voltage to one of the electrodes and a negative voltage to another of the electrodes in a first bipolar mode of operation such that the workpiece is electrostatically clamped to the ESC;
• plasma etching the at least one semiconductor layer by generating a plasma in the plasma chamber, wherein, at a period of time after the plasma is ignited, the operation of the ESC is switched to a monopolar mode of operation in which the electrodes have the same voltage applied to each electrode; and
• switching the operation of the ESC to a second bipolar mode of operation in which a positive voltage is applied to one of the electrodes and a negative voltage is applied to another of the electrodes.

2. A method according to claim 1, wherein the step of switching the operation of the ESC to a second bipolar mode of operation is performed after the step of plasma etching the at least one semiconductor layer has finished.

3. A method according to claim 1, wherein the step of switching the operation of the ESC to the second bipolar mode of operation is performed during the step of plasma etching the at least one semiconductor layer, optionally wherein: i) the step of plasma etching the at least one semiconductor layer comprises a first, bulk, etch phase in which a majority of the etching is performed until an end-point is reached, and a second, over etch phase, wherein the step of switching the operation of the ESC to a second bipolar mode of operation is performed on reaching the end point or during the second etch phase; and/or ii) the ESC is maintained in the second bipolar mode of operation for a period of time after the step of plasma etching the at least one semiconductor layer has finished.

4. A method according to any one of claims 1 to 3, wherein the step of plasma etching the at least one semiconductor layer comprises etching through the at least one semiconductor layer to form a plurality of discrete regions of semiconductor on the dielectric substrate, wherein the step of switching the operation of the ESC to a monopolar mode of operation is performed prior to the formation of the discrete regions of semiconductor.

5. A method according to any one of claims 1 to 4, wherein: i) the absolute value of the voltage applied to the electrodes in the first bipolar mode of operation is the same as the absolute value of the voltage applied to the electrodes in the second bipolar mode of operation; or ii) the absolute value of the voltage applied to the electrodes in the second bipolar mode of operation is lower than the absolute value of the voltage applied to the electrodes in the first bipolar mode of operation.

6. A method according to any one of claims 1 to 5, wherein, in the first bipolar mode of operation, a positive voltage is applied to a first electrode and a negative voltage is applied to a second electrode, and in the second bipolar mode of operation, a negative voltage is applied to the first electrode and a positive voltage is applied to the second electrode.

7. A method according to any one of claims 1 to 6, wherein: i) the absolute value of the voltage applied to at least one of the electrodes in the first bipolar mode of operation, monopolar mode of operation and/or second bipolar mode of operation can be up to 9000 V, optionally up to 6000 V; and/or ii) the absolute value of the voltage applied to at least one of the electrodes in the first bipolar mode of operation, monopolar mode of operation and/or second bipolar mode of operation can be at least 4000 V, optionally at least 5000 V.

8. A method according to any one of claims 1 to 7, wherein the method further comprises the step of:
• introducing one or more inert gases into at least one channel formed on the surface of the substrate support between the substrate support and the dielectric substrate.

9. A method according to claim 8, wherein: i) the step of introducing one or more inert gases comprises reducing the flow rate of the one or more inert gases during the period in which the ESC is in the second bipolar mode of operation, optionally wherein the flow rate of the one or more inert gases is reduced to zero, such that the flow of inert gas or inert gas mixture into the at least one channel is stopped; and/or ii) the one or more inert gases comprises at least one of He or Ar.

10. A method according to any one of claims 1 to 9, wherein: i) the at least one semiconductor layer comprises at least one Gallium Nitride layer; and/or ii) the dielectric substrate is formed of sapphire.

11. A plasma etching apparatus comprising:
• a plasma chamber;
• a plasma generation device;
• a controller; and
• a substrate support,
wherein the substrate support comprises an electrostatic chuck ("ESC"), the electrostatic chuck comprising:
• at least two electrodes;
• a power supply; and
• a layer of dielectric material covering the at least two electrodes and forming a substrate support surface,
wherein the controller is configured to switch the ESC between a first bipolar mode of operation, a monopolar mode of operation and a second bipolar mode of operation, wherein the first bipolar mode of operation comprises applying a positive voltage to one of the electrodes and a negative voltage to another of the electrodes, the second bipolar mode of operation comprises applying a positive voltage to one of the electrodes and a negative voltage to another of the electrodes and the monopolar mode of operation comprises applying the same voltage to each of the at least two electrodes, and wherein, during the generation of a plasma within the plasma chamber by the plasma generation device, the controller is configured to switch the ESC from the first bipolar mode of operation to the monopolar mode of operation whilst a plasma is generated within the plasma chamber.

12. An apparatus according to claim 11, wherein: i) the controller is configured to switch the ESC from the monopolar mode of operation to the second bipolar mode of operation once generation of a plasma within the plasma chamber is finished; or ii) during generation of a plasma within the plasma chamber by the plasma generation device, the controller is configured to switch the ESC from the monopolar mode of operation to the second bipolar mode of operation.

13. An apparatus according to claim 11 or claim 12, wherein the layer of dielectric material has a thickness of at least 0.5 mm, optionally wherein the layer of dielectric material has a thickness of at least 1 mm.

14. An apparatus according to any one of claims 11 to 13, wherein: i) the power supply is configured to supply a voltage having an absolute value of up to 9000 V, optionally up to 6000V, to at least one of the at least two electrodes; and/or ii) the power supply can be configured to supply a voltage having an absolute value of at least 4000 V, optionally at least 5000V, to at least one of the at least two electrodes.

15. An apparatus according to any one of claims 11 to 14, wherein: i) the layer of dielectric material comprises at least one sapphire, ceramic AlN or Al₂O₃ layer; and/or ii) the resistivity of the layer of dielectric material is at least 10¹² Ωcm at a temperature of 25 °C; and/or iii) the resistivity of the layer of dielectric material is up to 10¹⁵ Ωcm at a temperature of 25 °C; and/or iv) the dielectric constant of the layer of dielectric material is at least 7 at a temperature of 25 °C.
